# EUROPEAN PATENT APPLICATION

(11) **EP 4 625 820 A1**
(43) Date of publication of application: **01.10.2025**
(21) Application number: 24212895.7
(22) Date of filing: 14.11.2024
(51) Int. Cl.: H03K 17/082

(54) **SEMICONDUCTOR DEVICE AND POWER SEMICONDUCTOR SYSTEM INCLUDING THE SAME**

(30) Priority: 28.03.2024 KR 20240042693
(71) Applicant: Samsung Electronics Co., Ltd., Suwon-si, Gyeonggi-do 16677 (KR)
(72) Inventor: HWANG, In Jun, Suwon-si (KR)
(74) Representative: Marks & Clerk LLP

(57) **Abstract**

A semiconductor device includes: a high-electron mobility transistor; a short-circuit detection circuit configured to output a short-circuit protection voltage based on a gate voltage of the high-electron mobility transistor and a drain voltage of the high-electron mobility transistor; and a protection circuit configured to reduce the gate voltage of the high-electron mobility transistor based on the short-circuit protection voltage.

## Description

### BACKGROUND

### 1. Field

The present disclosure relates to a semiconductor device and a power semiconductor system including the same.

### 2. Description of the Related Art

In modern society, semiconductor devices are closely related to daily life. In particular, the importance of power semiconductor devices used in various fields such as transportation fields such as electric vehicles, railways, and electric trams, renewable energy systems such as solar power generation and wind power generation, and mobile devices is gradually increasing. The power semiconductor device is used to control high voltages or high currents, and performs functions such as electric power conversion and control in large electric power systems or high-power electronic devices. The power semiconductor devices have the ability and durability to process high electric power, process large amounts of current, and withstand high voltages. For example, the power semiconductor device may process voltages of hundreds to thousands of volts and currents of tens to thousands of amperes. The power semiconductor devices may improve the efficiency of electrical energy by minimizing power loss. The power semiconductor devices may be operated stably in environments such as high temperatures.

These power semiconductor devices may be classified according to materials, and for example, they may include a SiC power semiconductor device and a GaN electric power semiconductor device. By manufacturing the power semiconductor devices using SiC or GaN instead of existing silicon wafers (Si wafers), the drawbacks of silicon, which has unstable characteristics at high temperatures, may be compensated. The SiC power semiconductor devices are resistant to high temperatures and have low power loss, and may be suitable for electric vehicles, renewable energy systems, etc. The GaN power semiconductor devices require high costs, but are efficient in terms of speed and may be suitable for high-rate charging of mobile devices.

### SUMMARY

The present disclosure attempts to provide a semiconductor device including a reliability-improved high-electron mobility transistor.

An embodiment of the present disclosure provides a semiconductor device including: a high-electron mobility transistor; a short-circuit detection circuit configured to output, a short-circuit protection voltage based on a gate voltage of the high-electron mobility transistor and a drain voltage of the high-electron mobility transistor; and a protection circuit configured to reduce the gate voltage of the high-electron mobility transistor based on the short-circuit protection voltage.

Another embodiment of the present disclosure provides a semiconductor device including: a high-electron mobility transistor; a first transistor, wherein the first transistor is connected between a gate electrode of the high-electron mobility transistor and a second power voltage, and wherein a gate electrode of the first transistor is connected to a first node; a second transistor, wherein the second transistor is connected between a drain electrode of the high-electron mobility transistor and the first node, wherein a gate electrode of the second transistor is connected to the gate electrode of the high-electron mobility transistor; and a first resistor that is connected between the first node and the second power voltage.

Another embodiment of the present disclosure provides a power semiconductor system including: a high-electron mobility transistor; a gate driver configured to output a gate voltage to a gate electrode of the high-electron mobility transistor; and a short-circuit protection device connected to the gate electrode of the high-electron mobility transistor, wherein the short-circuit protection device includes: a short-circuit detection circuit configured to output a short-circuit protection voltage based on the gate voltage and a drain voltage of the high-electron mobility transistor; and a protection circuit configured to output a gate voltage of the high-electron mobility transistor based on the short-circuit protection voltage.

At least some of the above and other features of the invention are set out in the claims.

### BRIEF DESCRIPTION OF DRAWINGS

FIG. 1 is a block diagram of a power semiconductor system according to an embodiment.
FIG. 2 is a block diagram of a gate driver and a semiconductor device according to an embodiment.
FIG. 3 is a block diagram of a gate driver and a semiconductor device according to an embodiment.
FIG. 4 is a block diagram of a gate driver and a semiconductor device according to an embodiment.
FIG. 5 is a graph of current and voltage characteristics of a high-electron mobility transistor according to an embodiment.
FIG. 6 is a circuit diagram of a gate driver and a semiconductor device according to an embodiment.
FIG. 7 is a flowchart illustrating an operation of a detection circuit according to an embodiment.
FIG. 8 is a flowchart illustrating an operation of a gate driver according to an embodiment.
FIG. 9 is a circuit diagram of a gate driver and a semiconductor device according to an embodiment.
FIG. 10 is a circuit of a gate driver and a semiconductor device according to an embodiment.
FIG. 11 is a circuit of a gate driver and a semiconductor device according to an embodiment.
FIG. 12 is a circuit of a gate driver and a semiconductor device according to an embodiment.
FIG. 13 is a circuit of a gate driver and a semiconductor device according to an embodiment.
FIG. 14 is a circuit of a gate driver and a semiconductor device according to an embodiment.
FIG. 15 is a circuit of a gate driver and a semiconductor device according to an embodiment.
FIG. 16 is a circuit of a gate driver and a semiconductor device according to an embodiment.
FIG. 17 is a circuit diagram of a gate driver and a semiconductor device according to an embodiment.

### DETAILED DESCRIPTION

The present disclosure will be described more fully hereinafter with reference to the accompanying drawings, in which embodiments of the disclosure are shown. As those skilled in the art would realize, the described embodiments may be modified in various different ways, all without departing from the scope of the present disclosure.

The drawings and description are to be regarded as illustrative in nature and not restrictive, and like reference numerals designate like elements throughout the specification.

The size and thickness of each configuration shown in the drawings are arbitrarily shown for better understanding and ease of description, but the present disclosure is not limited thereto. In the drawings, the thickness of layers, films, panels, regions, etc., are enlarged for clarity. The thicknesses of some layers and areas are exaggerated for convenience of explanation.

It will be understood that when an element such as a layer, film, region, or substrate is referred to as being "on" another element, it can be directly on the other element or intervening elements may also be present. In contrast, when an element is referred to as being "directly on" another element, there are no intervening elements present. The word "on" or "above" means positioned on or below the object portion, and does not necessarily mean positioned "on" or "above" the upper side of the object portion based on a gravitational direction.

Unless explicitly described to the contrary, the word "comprise" and variations such as "comprises" or "comprising", will be understood to imply the inclusion of stated elements but not the exclusion of any other elements.

The phrase "on a plane" means viewing the object portion from the top, and the phrase "on a cross-section" means viewing a cross-section of which the object portion is vertically cut from the side.

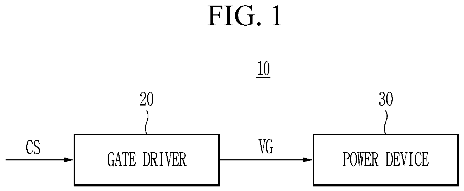

FIG. 1 shows a block diagram of a power semiconductor system.

Referring to FIG. 1, the power semiconductor system 10 may include a gate driver 20 and a semiconductor device (or a power device) 30.

The power semiconductor system 10 outputs electric power and may be used in several fields and/or devices, for example, electric vehicles, railways, or electric trams, renewable energy systems such as solar power generation and wind power generation, mobile devices, or home electronic devices. In an embodiment, the power semiconductor system 10 may include a semiconductor device 30 and a gate driver 20 for providing electrical signals to the semiconductor device 30.

The gate driver 20 may receive a control signal CS. The gate driver 20 may generate a gate voltage VG and may supply the gate voltage VG to the semiconductor device 30 based on a control signal CS. The control signal CS may control the gate driver 20. The control signal CS may be output from a control unit disposed outside the power semiconductor system 10. For example, the control signal CS may be output from microprocessors including a central processing unit (CPU) chip, a graphic processing unit (GPU) chip, an application processor (AP), etc. In embodiments, the control signal CS may be output from an integrated circuit (IC) included in the power semiconductor system 10. In an embodiment, the control signal CS may include a pulse width modulation (PWM) signal. In an embodiment, the gate driver 20 may generate a gate voltage VG having a desired size or waveform and may output the same based on information included in the control signal CS. The information included in the control signal CS may, for example, include a duty ratio of the PWM signal.

The gate voltage VG may control discrete semiconductor devices included in the semiconductor device 30. In detail, the gate voltage VG may be an electric signal provided to a terminal of the discrete semiconductor device included in the semiconductor device 30. In an embodiment, the gate voltage VG may have a greater value than the control signal CS. The gate driver 20 may convert the electrical signal received from outside the power semiconductor system 10 into a signal for controlling the discrete semiconductor devices included in the semiconductor device 30, and may provide the converted signal to the semiconductor device 30. In an embodiment, the gate driver 20 may function as a signal amplifier for processing quick on/off switching of the discrete semiconductor devices.

The semiconductor device 30 may include at least one or more configurations for converting, controlling, or distributing electric power. For example, the semiconductor device 30 may include elements such as an inverter, a converter, a power management IC (PMIC), and/or a power distribution unit (PDU). The elements (e.g., inverter, converter, PMIC, and PDU) included in the semiconductor device 30 may include various types of discrete semiconductor devices to convert, control, or distribute electric power. For example, the semiconductor device 30 may include the discrete semiconductor devices including transistors such as an IGBT or a MOSFET, diodes, and thyristors.

In an embodiment, the semiconductor device 30 may include the discrete semiconductor devices for performing switching operations. That is, the semiconductor device 30 may include the discrete semiconductor devices for performing the on/off operation according to levels of the gate voltage VG, and may control or convert supplying of electric power by controlling the on/off operations of the discrete semiconductor devices.

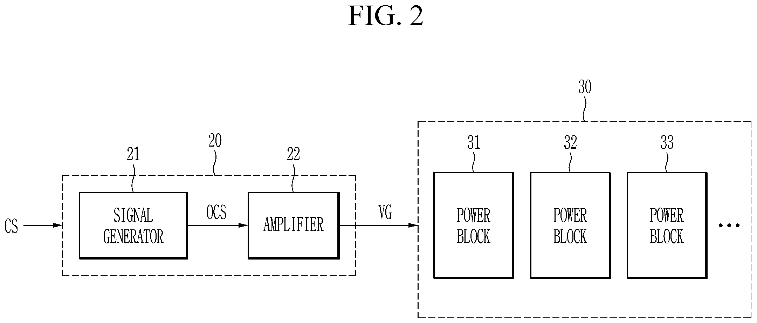

FIG. 2 shows a block diagram of a gate driver and a semiconductor device.

Referring to FIG. 2, the gate driver 20 may include a signal generator 21 and an amplifier 22, and the semiconductor device 30 may include unit blocks (or power blocks) 31, 32, and 33. The unit blocks 31, 32, and 33 may be a discrete semiconductor device for performing a unit function, or may be a set of the discrete semiconductor devices and/or passive elements configured to perform a unit function.

The signal generator 21 may generate an output control signal OCS based on the control signal CS. The output control signal OCS may control the output of the gate voltage VG output from the amplifier 22. The signal generator 21 may generate an output control signal OCS based on the control signal CS, and may provide the same to the amplifier 22.

The amplifier 22 may output the gate voltage VG to the semiconductor device 30 according to the output control signal OCS received from the signal generator 21. The signal output from an external microprocessor or an internal IC may have relatively less electric power, which may be insufficient in driving the high-power element such as the power semiconductor device. The gate driver 20 may receive the control signal CS is a low-power input signal, and based on this, it may output the signal of the gate voltage VG having high power to the outside, e.g., semiconductor device 30, through the amplifier 22. In an embodiment, the amplifier 22 may turn on a switching element included in the semiconductor device 30 or may output the gate voltage VG on a level of turning off the same based on the output control signal OCS.

The unit blocks 31, 32, and 33 may be a discrete semiconductor device for performing a unit function, or may be a set of the discrete semiconductor devices and/or passive elements configured to perform a unit function. The unit function may, for example, be a switching operation or a rectification operation. However, the functions performed by the respective unit blocks 31, 32, and 33 are not limited to the switching and the rectification operation. That is, the unit blocks 31, 32, and 33 may be designed to perform various operations performed by the known various types of the discrete semiconductor devices in addition to the switching operation and the rectification operation. The unit blocks 31, 32, and 33 may be included in the semiconductor device 30, and may perform the function of converting and controlling electric power like the inverter, the converter, and the PMIC with other unit blocks 31, 32, and 33 in the semiconductor device 30.

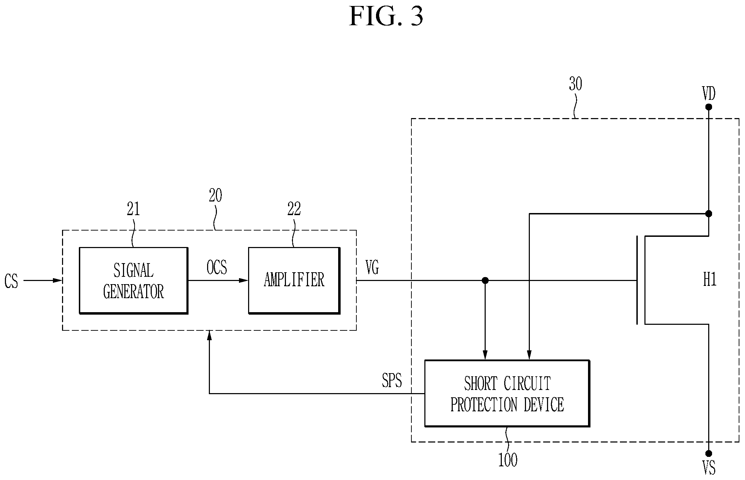

FIG. 3 shows a block diagram on configurations and operations of a gate driver and a semiconductor device according to an embodiment.

Referring to FIG. 3, the semiconductor device 30 includes a high-electron mobility transistor H1 and a short-circuit protection device 100. A high-electron mobility transistor may be any heterostructure FET (HFET) for example, or a modulation-doped FET (MODFET).

In an embodiment, the high-electron mobility transistor H1 may be a switching element included in one of the unit blocks 31, 32, and 33 described with reference to FIG. 2. The high-electron mobility transistor H1 may include a drain electrode and a source electrode. The drain electrode of the high-electron mobility transistor H1 may be connected to an individual circuit including at least one passive element and/or active elements and may be connected to an external power source. The source electrode of the high-electron mobility transistor H1 may be connected to an individual circuit including at least one passive elements and/or active elements. Referring to FIG. 3, a drain voltage VD represents a voltage at the drain electrode of the high-electron mobility transistor H1, and a source voltage VS represents a voltage at the source electrode of the high-electron mobility transistor H1.

A gate electrode of the high-electron mobility transistor H1 may be connected to an output end of the gate driver 20. The high-electron mobility transistor H1 may receive the gate voltage VG from an output end of the gate driver 20. The high-electron mobility transistor H1 may be turned on or turned off based on the level of the gate voltage VG provided by the gate driver 20. For example, the high-electron mobility transistor H1 may be turned on when a potential difference between the gate voltage VG and the drain electrode of the high-electron mobility transistor H1 has a level that is equal to or greater than a level of a threshold voltage of the high-electron mobility transistor H1. For example, the high-electron mobility transistor H1 may be turned off when the potential difference between the gate voltage VG and the drain electrode of the high-electron mobility transistor H1 has a lower level than the threshold voltage of the high-electron mobility transistor H1.

The short-circuit protection device 100 may prevent a breakdown of the high-electron mobility transistor H1 when a specific circuit in the semiconductor device 30 is short-circuited. A specific circuit in the semiconductor device 30 may be short-circuited when the gate driver 20 is erroneously operated or a specific load included in the semiconductor device 30 is bad.

For example, a portion around the circuit connected to the drain electrode of the high-electron mobility transistor H1 may be short-circuited. For example, a large amount of a short-circuit current may instantly flow to respective ends of the drain electrode and the source electrode of the high-electron mobility transistor H1. The short-circuit protection device 100 may prevent the breakdown of the high-electron mobility transistor H1 by the large short-circuit current flowing through the respective ends of the drain electrode and the source electrode of the high-electron mobility transistor H1.

The short-circuit protection device 100 may be connected to an output end of the gate driver 20 and may receive the gate voltage VG. The short-circuit protection device 100 may be connected the gate electrode of the high-electron mobility transistor H1. The short-circuit protection device 100 may be connected to the drain electrode of the high-electron mobility transistor H1 and may receive the drain voltage VD. In an embodiment, the short-circuit protection device 100 may detect the short-circuit of the high-electron mobility transistor H1 based on the voltage levels of the gate voltage VG and the drain voltage VD of the high-electron mobility transistor H1. In an embodiment, the short-circuit protection device 100 may output a short-circuit protecting signal SPS for turning off the high-electron mobility transistor H1 when the gate voltage VG and the drain voltage VD of the high-electron mobility transistor H1 are high. The short-circuit protection device 100 may provide the short-circuit protecting signal SPS to the gate driver 20. In an embodiment, the short-circuit protecting signal SPS may be a voltage signal. The gate driver 20 may output the gate voltage VG for turning on or turning off the high-electron mobility transistor H1 based on the voltage level of the short-circuit protecting signal SPS provided by the short-circuit protection device 100. For example, the gate driver 20 may output the gate voltage VG based on the voltage level of the control signal CS and the voltage level of the short-circuit protecting signal SPS.

In an embodiment, a plurality of short-circuit protection devices 100 may be provided corresponding to the number of the high-electron mobility transistors H1 included in the semiconductor device 30. For example, the semiconductor device 30 may include high-electron mobility transistors H1, and respective short-circuit protection devices 100 are connected to the gate electrodes of the respective high-electron mobility transistors H1. However, without being limited thereto, the semiconductor device 30 may have one short-circuit protection device 100 for each unit block (31 to 33, see FIG. 2). That is, the respective unit blocks 31, 32, and 33 described with reference to FIG. 2 may include high-electron mobility transistors H1, and the high-electron mobility transistors H1 included in the unit blocks 31, 32, and 33 may be connected in common to the short-circuit protection device 100. The short-circuit protection device 100 may output the short-circuit protecting signal SPS for turning off the high-electron mobility transistors H1 when at least one peripheral circuit from among the high-electron mobility transistors H1 is short-circuited. In this case, all the high-electron mobility transistors H1 may be turned off, or the high-electron mobility transistors H1 disposed around the short-circuited circuit from among the high-electron mobility transistors H1 may be turned off.

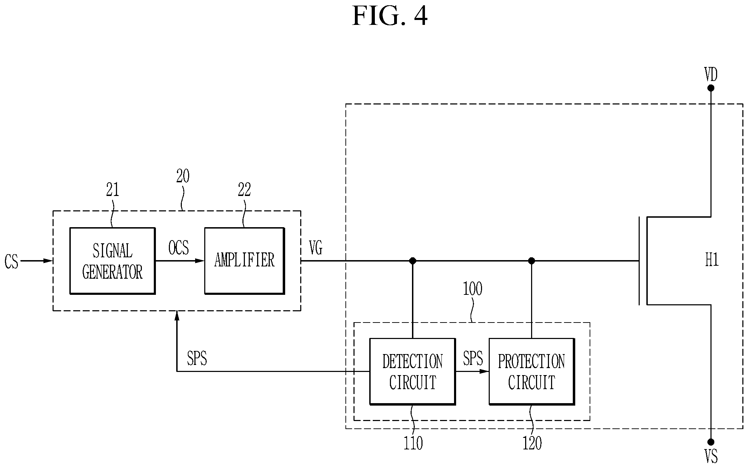

FIG. 4 shows a block diagram on configurations and operations of a gate driver and a semiconductor device according to an embodiment.

Referring to FIG. 4, the short-circuit protection device 100 may include a detection circuit 110 and a protection circuit 120.

The detection circuit 110 may detect a short-circuit state of an inside of the semiconductor device 30. The detection circuit 110 may generate a short-circuit protecting signal SPS and may output the short-circuit protecting signal SPS to the gate driver 20 and the protection circuit 120. In an embodiment, the short-circuit protecting signal SPS may be a voltage signal. In an embodiment, the detection circuit 110 may output the short-circuit protecting signal SPS having different levels based on the level of the gate voltage VG and the level of the drain voltage VD. The drain voltage VD may represent the voltage at the drain electrode of the high-electron mobility transistor H1. For example, the detection circuit 110 may output the short-circuit protecting signal SPS having the first level when the peripheral circuit of the high-electron mobility transistor H1 is short-circuited. The detection circuit 110 may output the short-circuit protecting signal SPS having a second level that is different from the first level when the high-electron mobility transistor H1 is not short-circuited. In an embodiment, the gate driver 20 may determine whether the high-electron mobility transistor H1 is short-circuited based on the voltage level of the short-circuit protecting signal SPS. The gate driver 20 may output the gate voltage VG for turning off the high-electron mobility transistor H1 when a short-circuit is generated.

The protection circuit 120 may lower the level of the gate voltage VG based on the short-circuit protecting signal SPS. The protection circuit 120 may protect the high-electron mobility transistor H1 from the breakdown caused by the short-circuit current until the high-electron mobility transistor H1 is completely turned off using the gate voltage VG for turning off the high-electron mobility transistor H1 after the short-circuit is generated. The protection circuit 120 may receive the short-circuit protecting signal SPS from the detection circuit 110, and may reduce the gate voltage VG based on the voltage level of the short-circuit protecting signal SPS. Hence, the high-electron mobility transistor H1 may be turned off, or the short-circuit current flowing between the drain electrode and the source electrode of the high-electron mobility transistor H1 may be reduced. In an embodiment, a time until the protection circuit 120 reduces the gate voltage VG after a short-circuit is generated may be shorter than a short-circuit withstand time (SCWT) of the high-electron mobility transistor H1.

The gate driver 20 may receive the control signal CS and the short-circuit protecting signal SPS, and may output the gate voltage VG for turning the high-electron mobility transistor H1 on or off based on the control signal CS and the short-circuit protecting signal SPS. The gate driver 20 may output the gate voltage VG for turning off the high-electron mobility transistor H1 when the peripheral circuit of the high-electron mobility transistor H1 is short-circuited. Accordingly, the gate driver 20 may protect the high-electron mobility transistor H1 from the breakdown caused by the short-circuit current.

According to the embodiment, the breakdown of the high-electron mobility transistor H1 may be prevented by two stages when the short-circuit is generated, thereby efficiently protecting the high-electron mobility transistor H1 under the short-circuit condition. In a first stage, when a portion around the high-electron mobility transistor H1 is short-circuited, the protection circuit 120 may reduce the gate voltage VG within the short-circuit withstand time (SCWT) of the high-electron mobility transistor H1 to reduce the short-circuit current flowing between the drain electrode and the source electrode of the high-electron mobility transistor H1. In a second stage, the gate driver 20 may output the gate voltage VG for turning off the high-electron mobility transistor H1 to completely turn off the high-electron mobility transistor H1.

The semiconductor device 30 may include a short-circuit detection circuit 110 for detecting short-circuit states, and a protection circuit 120 for reducing the gate voltage within the short-circuit withstand time (SCWT) based on the short-circuit protecting voltage output by the short-circuit detection circuit 110. According to an embodiment, in the short-circuit state, the semiconductor device may reduce the gate voltage of the high-electron mobility transistor within the short-circuit withstand time to prevent the breakdown of the high-electron mobility transistor caused by the short-circuit current and accordingly increase reliability of the high-electron mobility transistor.

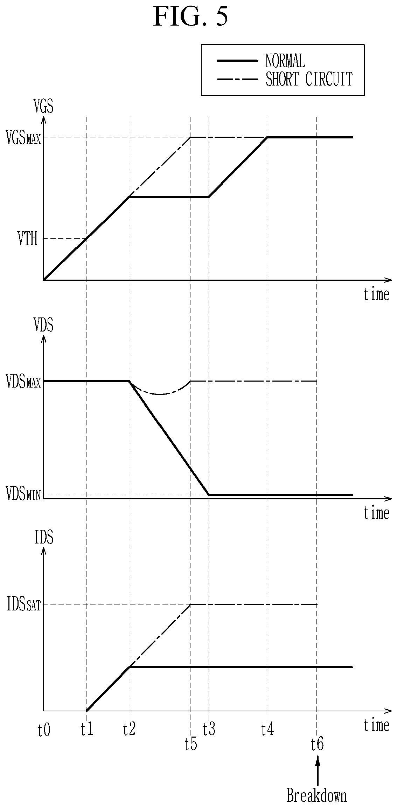

FIG. 5 shows a graph on current and voltage characteristics of a high-electron mobility transistor H1 in a normal state and a short-circuit state. In detail, FIG. 5 shows a graph of VGS, VDS and IDS with respect to time in a normal state (NORMAL) and a short-circuit (SHORT CIRCUIT) state. The VGS may indicate a voltage between the gate electrode and the source electrode of the high-electron mobility transistor H1, the VDS may be a voltage between the drain electrode and the source electrode of the high-electron mobility transistor H1, and the IDS may be the current flowing between the drain electrode and the source electrode of the high-electron mobility transistor H1.

In the normal state (NORMAL), the turn-on gate voltage VG from the gate driver 20 described with reference to FIG. 3 may be applied to the gate electrode of the high-electron mobility transistor H1. The gate-source voltage difference VGS may gradually increase, may maintain for a predetermined time according to a Miller effect (t2 to t3), and may reach a maximum value (VGS_{MAX}) (t4). The drain-source voltage difference VDS may maintain at the maximum value (VDS_{MAX}) for a predetermined period (t0 to t2), may start to reduce (t2), and may reach a minimum value (VDS_{MIN}) (t3). The drain-source current IDS may start to increase when the gate-source voltage difference VGS becomes equal to or greater than the threshold voltage VTH of the high-electron mobility transistor H1, and may be saturated (t2). The high-electron mobility transistor H1 may be designed to be operable in a linear region in the normal (NORMAL) state.

A voltage with a very high level may be applied between the drain electrode and the source electrode of the high-electron mobility transistor H1 in the short-circuit (SHORT CIRCUIT) state. For example, a portion around the circuit connected to the drain electrode of the high-electron mobility transistor H1 may be short-circuited, and a high voltage may be applied between the drain electrode and the source electrode of the high-electron mobility transistor H1 by the short-circuit current flowing to the drain electrode of the high-electron mobility transistor H1. In this case, the high-electron mobility transistor H1 may be operable in the saturation region.

The turn on gate voltage VG may be applied to the gate electrode of the high-electron mobility transistor H1 from the gate driver 20 described with reference to FIG. 3 in the short-circuit (SHORT CIRCUIT) state. The gate-source voltage difference VGS may gradually increase, and may reach the maximum value (VGS_{MAX}) (t5). In this case, a section (t2 to t3) for the gate-source voltage difference VGS to maintain a predetermined value may not be provided such as in the normal (NORMAL) state. Differing from the normal state (NORMAL), the drain-source voltage difference VDS may not be reduced and may maintain the maximum value (VDS_{MAX}) when the high-electron mobility transistor H1 is turned on in the short-circuit (SHORT CIRCUIT) state. With respect to the drain-source voltage difference VDS, the drain-source voltage difference VDS may be reduced for a predetermined period, and may be increased to the maximum value (VDS_{MAX}) (t2 to t3).

In other words, the gate-source voltage difference VGS and the drain-source voltage difference VDS may have the maximum values when the turn-on gate voltage VG is applied to the gate electrode of the high-electron mobility transistor H1 in the short-circuit (SHORT CIRCUIT) state.

The high-electron mobility transistor H1 may be operated in the saturation region so the drain-source current IDS may gradually increase, and may reach the saturated current (IDS_{SAT}) when the gate-source voltage difference VGS becomes the maximum value (VGS_{MAX}) (t5) in the short-circuit (SHORT CIRCUIT) state. When the IDS is the saturated current (IDS_{SAT}), and the drain-source voltage difference VDS maintains the maximum value (VDS_{MAX}), a very big power loss may be continuously generated at the respective ends of the high-electron mobility transistor H1 by P(electric power) = V(voltage) × I(current), and the high-electron mobility transistor H1 may breakdown after a predetermined time of t6 when the short-circuit withstand time (SCWT) of the high-electron mobility transistor H1 is from t6 to t0.

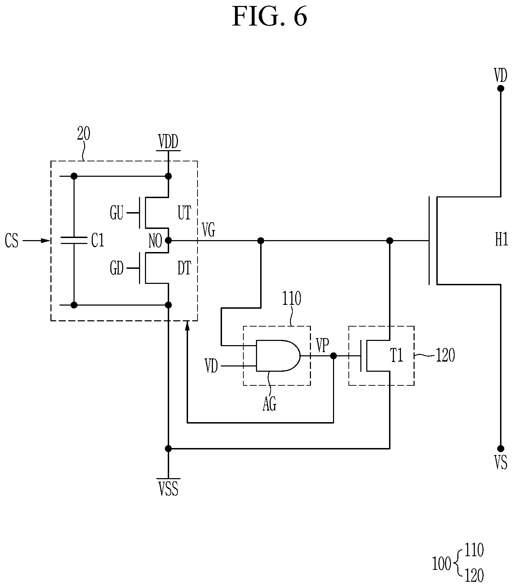

FIG. 6 to FIG. 8 show a circuit diagram and operations of a gate driver and a short-circuit protection device according to an embodiment.

FIG. 6 shows a circuit diagram of configurations of a gate driver 20 and a semiconductor device according to an embodiment. Referring to FIG. 6, the gate driver 20 may include a pull-up transistor UT, a pull-down transistor DT coupled in series to the pull-up transistor UT, and a first capacitor C1 coupled in parallel to the pull-up transistor UT and the pull-down transistor DT. A drain of the pull-up transistor UT and a first electrode of the first capacitor C1 may be connected to a second power voltage VDD. A source of the pull-down transistor DT and a second electrode of the first capacitor C1 may be connected to a first power voltage VSS. In several embodiments, the first power voltage VSS may have a lower level than the second power voltage VDD. However, without being limited thereto, in several embodiments, the first power voltage VSS may have a greater level than the second power voltage VDD. In several embodiments, the first power voltage VSS may be connected to the source electrode VS of the high-electron mobility transistor H1. A source electrode of the pull-up transistor UT, a drain electrode of the pull-down transistor DT, and a gate electrode of the first high-electron mobility transistor H1 may be connected to an output node NO. In an embodiment, the pull-up transistor UT and the pull-down transistor DT may be N-Channel Metal-Oxide (NMOS) transistors. However, without being limited thereto, in another embodiment, at least one of the pull-up transistor UT and the pull-down transistor DT may be a P-Channel Metal-Oxide (PMOS) transistor.

When the first high-electron mobility transistor H1 is turned on, a first-level pull-up signal GU may be applied to the gate electrode of the pull-up transistor UT. The first level may represent a voltage for turning on the pull-up transistor UT, and the potential difference between the first level of the pull-up signal GU and the output node NO may have a higher level than the threshold voltage of the pull-up transistor UT. When the first high-electron mobility transistor H1 is turned on, a second-level pull-down signal GD may be applied to the gate electrode of the pull-down transistor DT. The second level may represent a voltage for turning off the pull-down transistor DT. The pull-up transistor UT may be turned on and the pull-down transistor DT may be turned off so the second power voltage VDD may be applied to the gate electrode of the first high-electron mobility transistor H1. The second power voltage VDD having a higher level of voltage than the threshold voltage of the first high-electron mobility transistor H1 may be applied to the gate electrode of the first high-electron mobility transistor H1 so the first high-electron mobility transistor H1 may be turned on.

When the first high-electron mobility transistor H1 is turned on, the first-level pull-down signal GD may be applied to the gate of the pull-down transistor DT. The first level may be a voltage signal for turning on the pull-down transistor DT, and the potential difference between the first level of the pull-down signal GD and the first power voltage VSS may have a higher level than the threshold voltage of the pull-down transistor DT. When the first high-electron mobility transistor H1 is turned on, the second-level pull-up signal GU may be applied to the gate of the pull-up transistor UT. The second level may be a voltage for turning off the pull-up transistor UT. The pull-up transistor UT may be turned off and the pull-down transistor DT may be turned on so charges stored in the gate of the first high-electron mobility transistor H1 may be discharged through the first power voltage VSS, and the first high-electron mobility transistor H1 may be turned off.

The first capacitor C1 may be a decoupling capacitor. For example, when the first high-electron mobility transistor H1 is turned on, the voltage at the gate electrode of the first high-electron mobility transistor H1 may steeply fall to the same level as the first power voltage VSS. In this instance, the voltage at the drain of the pull-up transistor UT may not be influenced by the voltage at the gate electrode of the first high-electron mobility transistor H1 and may be maintained at the same level as the second power voltage VDD by the first capacitor C1.

Referring to FIG. 6, the detection circuit 110 may include a logic gate AG, and the protection circuit 120 may include a first transistor T1. The logic gate AG may receive the gate voltage VG and the drain voltage VD as input signals, and may output a short-circuit protecting voltage VP. The short-circuit protecting voltage VP may be the short-circuit protecting signal SPS described with reference to FIG. 3. In an embodiment, the logic gate AG may be an AND gate, but the disclosure is not limited herein.

The logic gate AG may compare the drain voltage VD and the gate voltage VG to first and second reference voltages VREF1 and VREF2, and may output the short-circuit protecting voltage VP with different levels based on the comparison. In an embodiment, the reference voltages VREF1 and VREF2 may be references for determining a logic high or a logic low of the signals input to the logic gate AG. In several embodiments, the first reference voltage VREF1 may be set to have a level that is less than the maximum value (VDS_{MAX}) of the VDS and is greater than the minimum value (VDS_{MIN}). In several embodiments, the second reference voltage VREF2 may be set to have a level that is less than the gate voltage VG for turning on the high-electron mobility transistor H1 and is greater than the gate voltage VG for turning off the high-electron mobility transistor H1. In an embodiment, the first reference voltage VREF1 and the second reference voltage VREF2 may have substantially the same level.

In an embodiment, the detection circuit 110 may determine the peripheral circuit of the high-electron mobility transistor H1 is in the short-circuit (SHORT CIRCUIT) state when the gate voltage VG and the drain voltage VD have the high level. In this case, the detection circuit 110 may output the short-circuit protecting voltage VP for protecting the high-electron mobility transistor H1. That is, the logic gate AG may output a first-level short-circuit protecting voltage VP when the drain voltage VD has a level that is equal to or greater than that of the first reference voltage VREF1, and the gate voltage VG has a level that is equal to or greater than that of the second reference voltage VREF2. The first-level short-circuit protecting voltage VP may have a voltage level for turning on the first transistor T1. For example, the first level may have a voltage level that is equal to or greater than the threshold voltage of the first transistor T1. When the first transistor T1 is turned on, the second power voltage VDD may be divided into the respective ends of the transistors UT and T1 according to a ratio of drain-source resistance (Rdson) of the pull-up transistor UT and the first transistor T1. In this case, the lower gate voltage VG compared to the case in which the first transistor T1 is turned off may be applied to the gate electrode of the first high-electron mobility transistor H1. Hence, when the short-circuit is generated, the first high-electron mobility transistor H1 may be turned off, or the short-circuit current flowing between the drain electrode and the source electrode of the first high-electron mobility transistor H1 may be reduced.

The gate driver 20 may receive the short-circuit protecting voltage VP, and may output the gate voltage VG for turning off the high-electron mobility transistor H1. In an embodiment, the gate driver 20 may receive the control signal CS for turning on the pull-up transistor UT and turning off the pull-down transistor DT and the first-level short-circuit protecting voltage VP. When receiving the first-level short-circuit protecting voltage VP, and receiving the control signal CS for turning on the pull-up transistor UT and turning off the pull-down transistor DT, the gate driver 20 may generate a second-level pull-up signal GU for turning off the pull-up transistor UT and a first-level pull-down signal GD for turning on the pull-down transistor DT. Therefore, the gate driver 20 may output the gate voltage VG on the level of the first power voltage VSS.

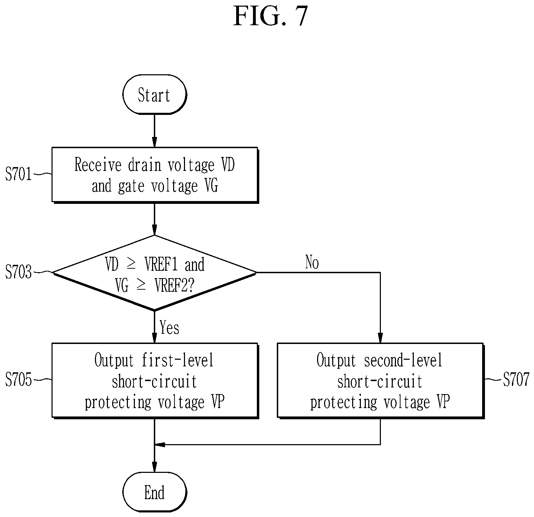

FIG. 7 shows a flowchart on an operation of a detection circuit according to an embodiment.

Referring to FIG. 7, at operation S701, the detection circuit 110 receives the drain voltage VD and the gate voltage VG. The detection circuit 110 determines whether the peripheral circuit is short-circuited based on the drain voltage VD and the gate voltage VG, and outputs the short-circuit protecting voltage VP based on the determination result.

At operation S703, the detection circuit 110 may compare the levels of the drain voltage VD and the gate voltage VG to the levels of the first reference voltage VREF1 and the second reference voltage VREF2. The detection circuit 110 may determine whether the drain voltage VD is equal to or greater than the first reference voltage VREF1, and whether the gate voltage VG is equal to or greater than the second reference voltage VREF2.

At operation S705, when the drain voltage VD is equal to or greater than the first reference voltage VREF1, and the gate voltage VG is equal to or greater than the second reference voltage VREF2, the detection circuit 110 may output the first-level short-circuit protecting voltage VP. The first-level short-circuit protecting voltage VP may have a voltage level for turning on the first transistor T1 described with reference to FIGS 5 and 6. When the first transistor T1 is turned on, the gate voltage VG of the high-electron mobility transistor H1 (see FIG. 5) may be reduced.

At operation S707, the detection circuit 110 may output the second-level short-circuit protecting voltage VP when either the drain voltage VD is less than the first reference voltage VREF1, or the gate voltage VG is less than the second reference voltage VREF2, or both. For example, the detection circuit 110 may output the second-level short-circuit protecting voltage VP when the drain voltage VD is less than the first reference voltage VREF1, when the gate voltage VG is less than the second reference voltage VREF2, or when the drain voltage VD is less than the first reference voltage VREF1 and the gate voltage VG is less than the second reference voltage VREF2. The second-level short-circuit protecting voltage VP may have the voltage level for turning off the first transistor T1 described with reference to FIGS. 5 and 6.

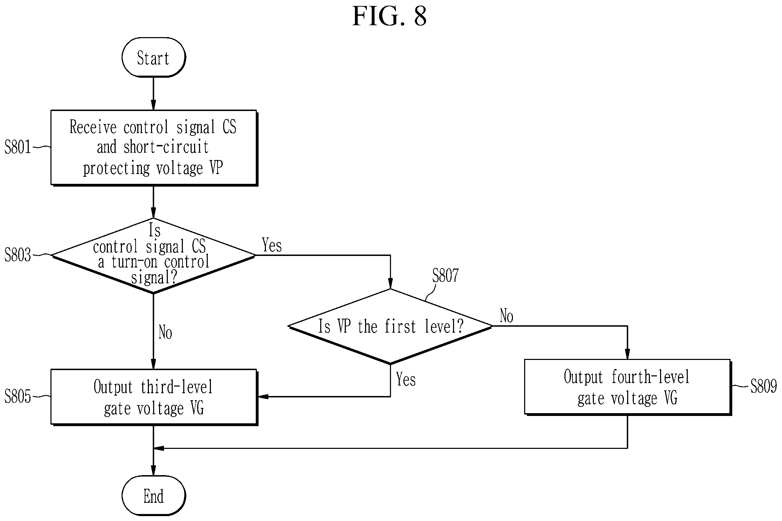

FIG. 8 shows a flowchart on an operation of a gate driver 20 according to an embodiment.

At operation S801, the gate driver 20 may receive a control signal CS, and may receive a short-circuit protecting voltage VP from the detection circuit 110. The control signal CS may control the gate driver 20. For example, the control signal CS may be a turn-on control signal for turning on the high-electron mobility transistor H1 or a turn-off control signal for turning off the high-electron mobility transistor H1. The gate driver 20 may output the gate voltage VG for turning on the high-electron mobility transistor H1 or the gate voltage VG for turning off the high-electron mobility transistor H1 based on the control signal CS.

At operation S803, the gate driver 20 may determine whether the control signal CS is a turn-on control signal or a turn-off control signal.

At operation S805, when the control signal CS is not the turn-on control signal or is the turn-off control signal, the gate driver 20 may output a third-level gate voltage VG. The third level may be the voltage level for turning off the high-electron mobility transistor H1. For example, the third level may have a lower voltage level than the threshold voltage of the high-electron mobility transistor H1. The high-electron mobility transistor H1 may be turned off when the third-level gate voltage is applied to the gate electrode of the high-electron mobility transistor H 1.

At operation S807, when the control signal CS is the turn-on control signal, the gate driver 20 may determine whether the short-circuit protecting voltage VP has the first level. The first level may be the voltage level for turning on the first transistor T1 described with reference to FIG. 6. At S805, when the short-circuit protecting voltage VP has the first level, the gate driver 20 may output the third-level gate voltage VG.

When the short-circuit protecting voltage VP is not the first level, the gate driver 20 may output a fourth-level gate voltage VG. The fourth level may be the voltage level for turning on the high-electron mobility transistor H1. For example, the fourth level may be the higher voltage level than the threshold voltage of the high-electron mobility transistor H1. The high-electron mobility transistor H1 may be turned on when the fourth-level gate voltage is applied to the gate electrode of the high-electron mobility transistor H1.

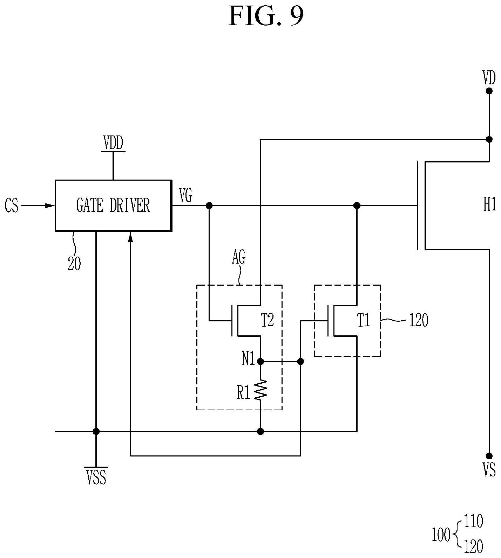

FIG. 9 shows a circuit diagram on a gate driver and a semiconductor device according to an embodiment. Specifically, FIG. 9 may show a detailed circuit diagram of the logic gate AG described with reference to FIG. 6.

Referring to FIG. 9, the logic gate AG may include a second transistor T2 connected between the drain electrode of the high-electron mobility transistor H1 and a first node N1 and a first resistor R1 connected between the first power voltage VSS and the first node N1. A gate electrode of the second transistor T2 may be connected to an output end of the gate driver 20 or the gate electrode of the high-electron mobility transistor H1.

In an embodiment, the second transistor T2 and the first resistor R1 may be operable as an AND gate, but the disclosure is not limited to herein. The gate electrode and a drain electrode of the second transistor T2 may function as two input ends of the AND gate. Referring to FIG. 9, the gate voltage VG output by the gate driver 20 may be input to the gate electrode of the second transistor T2. The drain voltage VD of the high-electron mobility transistor H1 may be input to the drain electrode of the second transistor T2. The first node N1 may be an output node of the AND gate. The second transistor T2 may be turned on when the gate voltage VG that is a high voltage, for example, the fourth-level gate voltage described with reference to FIG. 8 is input to the gate electrode, and it may output the short-circuit protecting voltage VP (see FIG. 6) through the first node N1. The voltage level of the short-circuit protecting voltage VP may be modulated according to resistance of the first resistor R1. In an embodiment, when the high voltage is input to the gate electrode and the drain electrode of the second transistor T2, resistance of the first resistor R1 may be selected so that the short-circuit protecting voltage VP having a higher level than the threshold voltage of the first transistor T1 may be output from the first node N1.

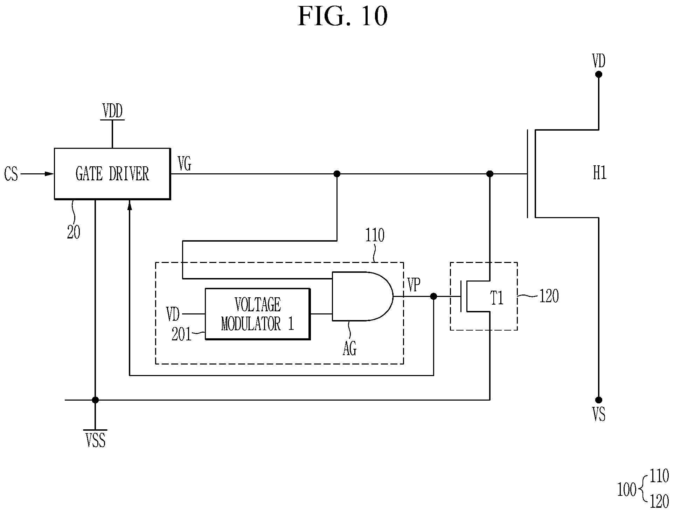

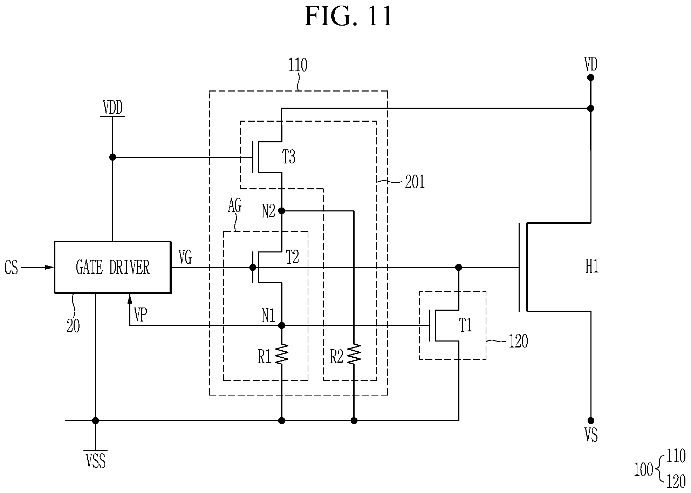

FIG. 10 and FIG. 11 show circuit diagrams on a gate driver and a semiconductor device according to an embodiment. The gate driver 20 and the semiconductor device 30 shown in FIG. 10 and FIG. 11 largely correspond to the above-described embodiments. Accordingly, some differences in FIGS. 10 and 11 are described. The semiconductor device 30 may further include the first voltage modulator 201. Referring to FIG. 10 and FIG. 11, the detection circuit 110 may further include a first voltage modulator 201 disposed between the logic gate AG and the drain electrode drain electrode of the high-electron mobility transistor H1.

The first voltage modulator 201 may include a clipper circuit. For example, the first voltage modulator 201 may modulate the voltage level of the drain voltage VD input to the input end of the logic gate AG. When a short-circuit is generated, a large drain voltage VD may be applied to the drain electrode of the high-electron mobility transistor H1. The first voltage modulator 201 may modulate the drain voltage VD to an appropriate voltage (e.g., a voltage with a lower level than the drain voltage VD), and may provide a resultant voltage to the input end of the logic gate AG.

Referring to FIG. 11, the first voltage modulator 201 may include a third transistor T3 connected between the drain electrode of the high-electron mobility transistor H1 and the second transistor T2. The first voltage modulator 201 may include a second resistor R2 connected between a second node N2 and the first power voltage VSS with N2 being between the second transistor T2 and the third transistor T3. The second power voltage VDD may be applied to the gate electrode of the third transistor T3. The third transistor T3 may be turned on by the second power voltage VDD, may modulate the voltage level of the drain voltage VD, and may output the modulated voltage to the second node N2. In an embodiment, the voltage at the second node N2 may have a smaller level than the drain voltage VD. The voltage at the second node N2 may be modulated based on the resistance of the second resistor R2.

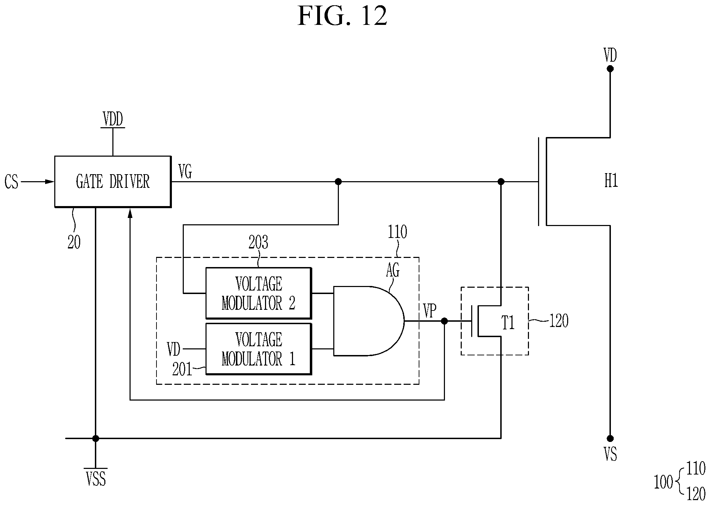

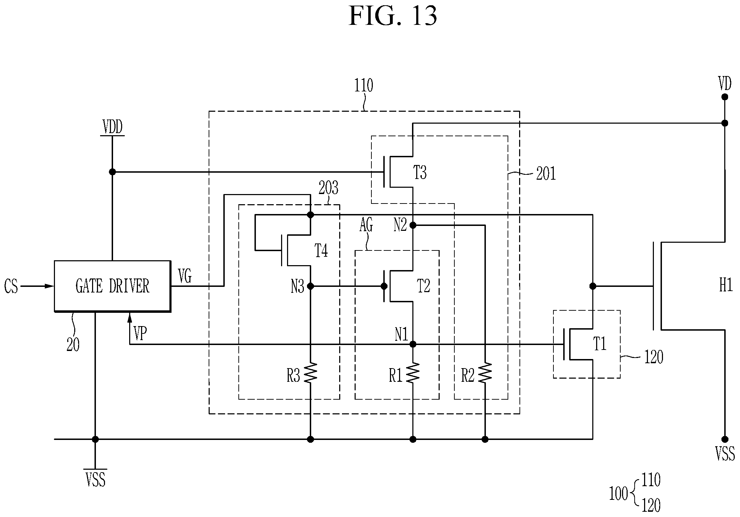

FIG. 12 and FIG. 13 show circuit diagrams on a gate driver and a semiconductor device according to an embodiment. The gate driver 20 and the semiconductor device 30 shown in FIG. 12 and FIG. 13 largely correspond to the above-described embodiments, and accordingly, differences are described. The semiconductor device 30 may further include a second voltage modulator 203 in addition to the first voltage modulator 201. Referring to FIG. 12 and FIG. 13, the detection circuit 110 may include a second voltage modulator 203 disposed between the logic gate AG and the gate electrode of the high-electron mobility transistor H1.

The second voltage modulator 203 may further include a voltage dividing circuit (or a divider). For example, the second voltage modulator 203 may modulate the voltage level of the gate voltage VG input to the input end of the logic gate AG. The second voltage modulator 203 may modulate the gate voltage VG to an appropriate voltage, and may provide the modulated voltage to the input end of the logic gate AG.

Referring to FIG. 13, the second voltage modulator 203 may include a fourth transistor T4 connected between the gate electrode of the high-electron mobility transistor H1 and the gate electrode of the second transistor T2. The second voltage modulator 203 may include a third resistor R3 connected between the third node N3 and the first power voltage VSS with N3 being between the fourth transistor T4 and the gate electrode of the second transistor T2. The gate electrode of the third transistor T3 may be connected to the drain electrode of the third transistor T3. The fourth transistor T3 may be turned on when the gate voltage VG is a high voltage, for example, the fourth-level gate voltage described with reference to FIG. 8. In this instance, the voltage at the third node N3 may be modulated according to resistance of the third resistor R3.

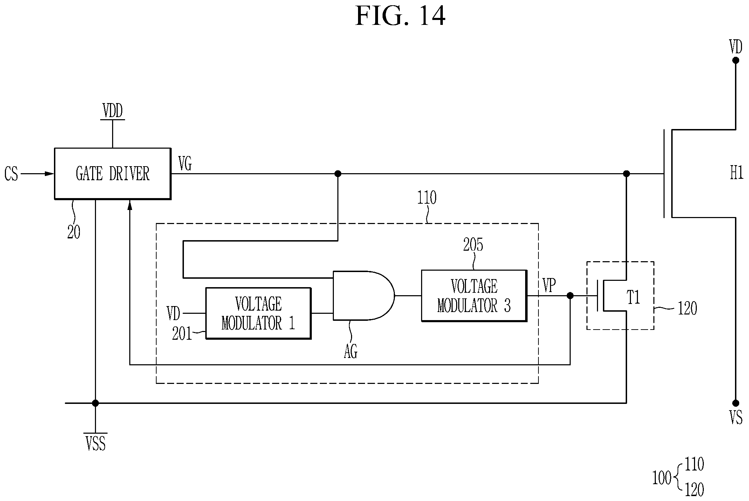

FIG. 14 to FIG. 16 show circuit diagrams on a gate driver and a semiconductor device according to an embodiment. The gate driver 20 and the semiconductor device 30 shown in FIG. 14 to FIG. 16 largely correspond to the above-described embodiments, and accordingly, differences are described. The semiconductor device 30 may further include a third voltage modulator 205. Referring to FIG. 14 to FIG. 16, the detection circuit 110 may include the third voltage modulator 205 disposed between the output end of the logic gate AG and the gate electrode of the first transistor T1. It is understood that in embodiments, the detection circuit 110 may include the third voltage modulator 205 in addition to the first voltage modulator 201, the second voltage modulator 203, or both.

The third voltage modulator 205 may include a digitizer circuit. The digitizer circuit may convert analog signals into digital signals. The third voltage modulator 205 may convert the voltage signal output by the output end of the logic gate AG into a digital signal and may output the digital signal to the outside as the short-circuit protecting voltage VP.

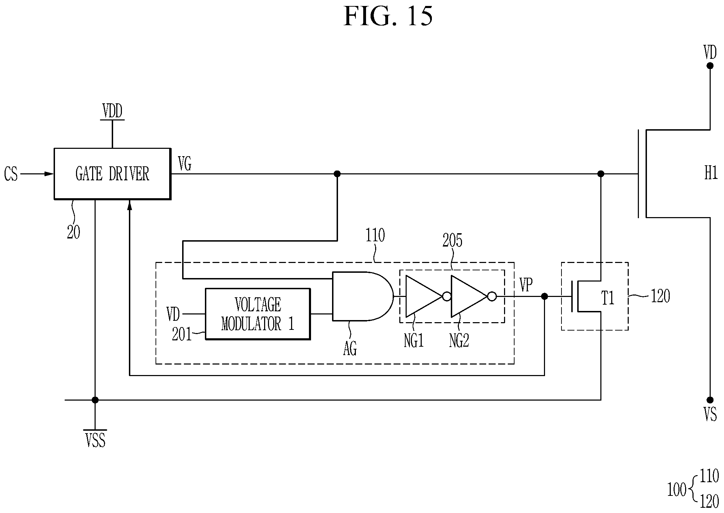

The third voltage modulator 205 may include an even number of inverter circuits coupled in series to each other. Referring to FIG. 15, the third voltage modulator 205 may include two inverter circuits NG1 and NG2 coupled in series. The first inverter circuit NG1 may be connected between the output end of the logic gate AG and an input end of the second inverter circuit NG2. The second inverter circuit may be connected between the output end of the first inverter circuit NG1 and the gate electrode of the first transistor T1. In an embodiment, the first inverter circuit NG1 may convert the voltage signal output by the logic gate AG into a digital signal may output the same. In an embodiment, the second inverter circuit NG2 may invert the digital signal output by the first inverter circuit NG1 and may output the inverted signal as the short-circuit protecting voltage VP.

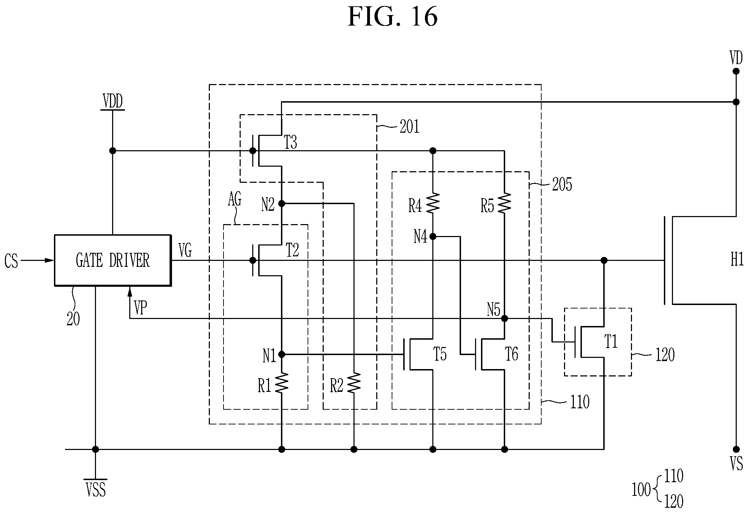

Referring to FIG. 16, the third voltage modulator 205 may include a fifth transistor T5 connected between the fourth node N4 and the first power voltage VSS and having a gate electrode connected to the first node N1. The third voltage modulator 205 may include a fourth resistor R4 connected between the fourth node N4 and the second power voltage VDD. The fifth transistor T5 and the fourth resistor R4 may be operable as the first inverter circuit NG1.

The third voltage modulator 205 may further include a sixth transistor T6 connected between the fifth node N5 and the first power voltage VSS and having a gate electrode connected to the fourth node N4. It may include a fifth resistor R5 connected between the fifth node N5 and the second power voltage VDD. The fifth node N5 may be connected to the gate electrode of the first transistor T1 and the gate driver 20. The sixth transistor T6 and the fifth resistor R5 may be operable as the second inverter circuit NG2.

Referring to FIG. 16, the fifth transistor T5 may be turned on when the potential difference between the voltage at the first node N1 and the first power voltage VSS is a high voltage, for example, a voltage at the first power voltage VSS is higher than the threshold voltage of the fifth transistor T5. In this instance, the first power voltage VSS may be applied to the fourth node N4. The sixth transistor T6 may be turned off when the voltage at the fourth node N4 is the first power voltage VSS. In this instance, the second power voltage VDD may be applied to the fifth node N5. In an embodiment, the potential difference between the second power voltage VDD and the first power voltage VSS may have a higher voltage than the threshold voltage of the first transistor T1. Hence, the first transistor T1 may be turned on.

The fifth transistor T5 may be turned off when the potential difference between the voltage at the first node N1 and the first power voltage VSS is a low voltage, for example, when the first power voltage VSS is less than the threshold voltage of the fifth transistor T5. In this instance, the second power voltage VDD may be applied to the fourth node N4. The sixth transistor T6 may be turned on when the voltage at the fourth node N4 is the second power voltage VDD. In this instance, the first power voltage VSS may be applied to the fifth node N5. Hence, the first transistor T1 may be turned off.

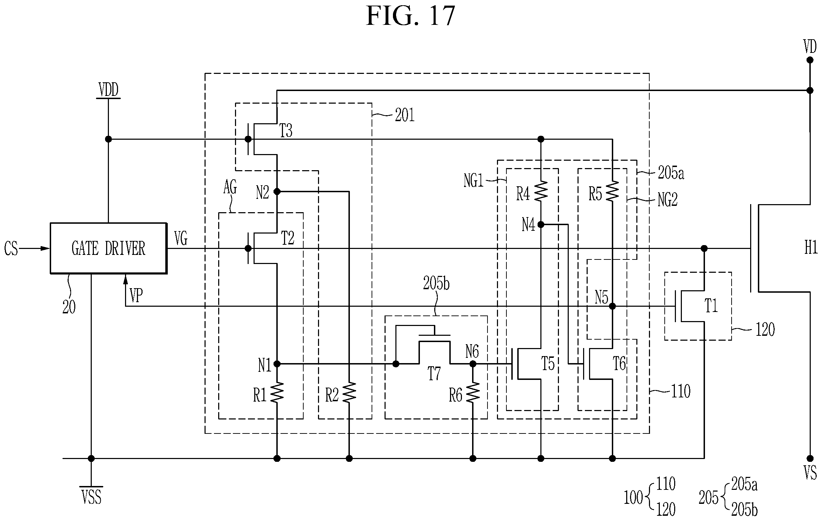

FIG. 17 shows a circuit diagram on a gate driver and a semiconductor device according to an embodiment. The gate driver 20 and the semiconductor device 30 shown in FIG. 17 largely correspond to the above-described embodiments, and accordingly, differences are described. Regarding the semiconductor device 30, the third voltage modulator 205 may further include the voltage dividing circuit (or divider), which is partly different from the above-described embodiments.

Referring to FIG. 17, the third voltage modulator 205 may include an inverter circuit 205a and a voltage modulation circuit 205b connected between the inverter circuit 205a and the logic gate AG. The voltage modulation circuit 205b may be a voltage dividing circuit (or divider). For example, the voltage modulation circuit 205b may modulate the voltage level of the voltage input to an input end (e.g., a gate electrode of the fifth transistor T5) of the first inverter circuit NG1. The voltage modulation circuit 205b may modulate the voltage output from the output end (e.g., the first node N1) of the logic gate AG to an appropriate voltage, and may provide the modulated voltage to the input end (e.g., the gate electrode of the fifth transistor T5) of the first inverter circuit NG1.

The voltage modulation circuit 205b may include seventh transistor T7 connected between the first node N1 and the gate electrode of the fifth transistor T5, and a sixth resistor R6 connected between a sixth node N6 between the gate electrode of the fifth transistor T5 and the seventh transistor T7 and the first power voltage VSS. A gate electrode of the seventh transistor T7 may be connected to a drain electrode of the seventh transistor T7. The seventh transistor T7 may be turned on when the voltage output from the first node N1 is a high voltage. In this instance, the voltage at the sixth node N6 may be modulated according to resistance of the sixth resistor R6.

While this disclosure has been described in connection with what is presently considered to be practical embodiments, it is to be understood that the disclosure is not limited to the disclosed embodiments, but, on the contrary, is intended to cover various modifications and equivalent arrangements included within the scope of the appended claims.

## Claims

1. A semiconductor device comprising:
a high-electron mobility transistor;
a short-circuit detection circuit configured to output a short-circuit protection voltage based on a gate voltage of the high-electron mobility transistor and a drain voltage of the high-electron mobility transistor; and
a protection circuit configured to reduce the gate voltage of the high-electron mobility transistor based on the short-circuit protection voltage.

2. The semiconductor device of claim 1, wherein the protection circuit comprises a first transistor,
wherein the first transistor is connected between a gate electrode of the high-electron mobility transistor and a first power voltage, and
wherein a gate electrode of the first transistor is configured to receive the short-circuit protection voltage from the short-circuit detection circuit.

3. The semiconductor device of claim 2, wherein the short-circuit detection circuit comprises an AND gate circuit,
wherein the AND gate circuit comprises a first input end for receiving the gate voltage of the high-electron mobility transistor and a second input end for receiving the drain voltage, and
wherein the AND gate circuit further comprises an output end for outputting the short-circuit protection voltage.

4. The semiconductor device of claim 3, wherein the AND gate circuit is configured to:
output a first-level short-circuit protection voltage when the drain voltage of the high-electron mobility transistor and the gate voltage of the high-electron mobility transistor have levels higher than or equal to a reference voltage; and
output a second-level short-circuit protection voltage when at least one of the drain voltage of the high-electron mobility transistor and the gate voltage of the high-electron mobility transistor has a lower level than the reference voltage, and
wherein the first-level short-circuit protection voltage is equal to or greater than a threshold voltage of the first transistor, the second-level short-circuit protection voltage is less than the threshold voltage of the first transistor, and the second-level short-circuit protection voltage is lower than the first-level short-circuit protection voltage.

5. The semiconductor device of claim 3 or 4, wherein the AND gate circuit comprises:
a second transistor, the second transistor being connected between a drain electrode of the high-electron mobility transistor and a first node connected to the gate electrode of the first transistor, and the second transistor having a gate electrode of the AND gate circuit is connected to the gate electrode of the high-electron mobility transistor, and
a first resistor that is connected between the first power voltage and the first node.

6. The semiconductor device of claim 5, further comprising:
a first voltage modulator connected between the drain electrode of the high-electron mobility transistor and the first input end,
wherein the first voltage modulator comprises:
a third transistor, wherein the third transistor is connected between the drain electrode of the high-electron mobility transistor and the second transistor, and wherein a gate electrode of the third transistor is connected to a second power voltage; and
a second resistor connected between the third transistor and the first power voltage.

7. The semiconductor device of claim 5 or 6, further comprising
a second voltage modulator connected between the gate electrode of the high-electron mobility transistor and the second input end of the AND gate circuit,
wherein the second voltage modulator comprises:
a fourth transistor, wherein the fourth transistor is connected between the gate electrode of the high-electron mobility transistor and the gate electrode of the second transistor; and
a third resistor connected between the fourth transistor and the first power voltage, and
wherein a source electrode of the fourth transistor and a gate electrode of the fourth transistor are connected to each other.

8. The semiconductor device of claim 5, 6 or 7, and further comprising a third voltage modulator connected between the output end of the AND gate circuit and the gate electrode of the first transistor,
wherein the third voltage modulator comprises an even number of inverter circuits coupled in series to each other.

9. The semiconductor device of claim 5, 6 or 7, further comprising a third voltage modulator connected between the first node and the gate electrode of the first transistor,
wherein the third voltage modulator comprises:
a fifth transistor that is connected between a second node and the first power voltage, wherein a gate electrode the fifth transistor is connected to the first node;
a fourth resistor that is connected between the second node and a second power voltage;a sixth transistor that is connected between a third node and the first power voltage, wherein a gate electrode the sixth transistor is connected to the second node; and
a fifth resistor connected between the third node and the second power voltage, and
wherein the gate electrode of the first transistor is connected to the third node.

10. The semiconductor device of claim 9, wherein the third voltage modulator further comprises:
a seventh transistor connected between a fourth node and the first node;
a gate electrode of the seventh transistor is connected to a source electrode of the seventh transistor; and
a sixth resistor connected between the fourth node and the first power voltage, and
wherein the gate electrode of the fifth transistor is connected to the fourth node.

11. A power semiconductor system comprising the semiconductor device of any one preceding claim, and
a gate driver configured to output a gate voltage to a gate electrode of the high-electron mobility transistor.

12. The power semiconductor system of claim 11, wherein the gate driver is configured to output a third-level gate voltage for turning on the high-electron mobility transistor or a fourth-level gate voltage for turning off the high-electron mobility transistor based on a control signal and the short-circuit protection voltage, and
wherein the gate driver is configured to output the third-level gate voltage for turning off the high-electron mobility transistor when the short-circuit protection voltage has the first level.

13. The power semiconductor system of claim 11 or 12, wherein the gate driver comprises:
a pull-up transistor connected between an output node for outputting the gate voltage and a second power voltage; and
a pull-down transistor connected between the output node and a first power voltage, and
when the short-circuit protection voltage has the first level, the pull-up transistor is turned off and the pull-down transistor is turned on.
